# EUROPEAN PATENT SPECIFICATION

(11) **EP 2 921 571 B1**
(45) Date of publication and mention of the grant of the patent: **01.02.2017**
(21) Application number: 12888566.2
(22) Date of filing: 13.11.2012
(51) Int. Cl.: C23C 14/24

(54) **VACUUM VAPOR DEPOSITION APPARATUS**
VAKUUMDAMPFABSCHEIDUNGSVORRICHTUNG
APPAREIL DE DÉPÔT PAR ÉVAPORATION SOUS VIDE

(43) Date of publication of application: 23.09.2015
(73) Proprietor: Mitsubishi Heavy Industries, Ltd., Tokyo 108-8215 (JP)
(72) Inventor: SHIGEOKA, Nobuyuki, Tokyo 108-8215 (JP)
(74) Representative: Hoffmann Eitle
(86) International application number: PCT/JP2012/079420
(87) International publication number: WO 2014/076770

(56) References cited:
- JP-A- H1 025 563
- JP-A- 2005 325 391
- JP-A- 2007 077 419
- JP-A- 2007 297 704
- JP-A- 2008 276 998
- JP-A- 2009 064 758
- JP-A- 2009 120 924
- JP-A- 2012 012 689
- US-A1- 2006 145 103

## Description

### Technical Field

The present invention relates to a vacuum vapor deposition apparatus that vapor-deposits a vapor deposition material on a target.

### Background Art

Vacuum vapor deposition apparatuses, which form a thin film on a substrate or the like through vapor deposition, include an evaporation source that contains a vapor deposition material. The evaporation source is heated by a heater or the like to thereby discharge the vapor deposition material. The discharged vapor deposition material is vapor-deposited on a substrate that is disposed on the upper side. In such vacuum vapor deposition apparatuses, a film thickness sensor is provided in order to form a film at a desired film formation speed, and the film formation is performed monitoring the film formation speed using this film thickness sensor. As the film thickness sensor, a film thickness sensor using a crystal oscillator is known as an example. If the vapor deposition material adheres to this crystal oscillator, resonant frequency changes, and the film formation speed of the vapor deposition material vapor-deposited on the substrate is estimated on the basis of this change (refer to JP 2009 120924 A).

### Citation List

### Patent Literature

Both JP 2009 120924 A and JP S60 93303 A represent the closest prior art and disclose a vacuum vapor deposition apparatus with the pre-characterizing features of claim 1.

### Summary of Invention

### Technical Problem

However, in a vapor deposition apparatus as described in JP 2009 120924 A, when a target, such as a substrate, passes above the evaporation source, the heat dissipated from the evaporation source is reflected by the target. If this reflected heat is radiated to the crystal oscillator of the film thickness sensor, the temperature of the crystal oscillator changes and thereby frequency characteristics change. For this reason, since the monitoring of the film formation speed is affected and a precise film formation speed cannot be measured, there is a problem in that it is not possible to precisely control the film formation speed.

JP 2009 120924 A discloses that the film formation speed is measured with higher precision by cooling the crystal oscillator with a refrigerant and raising the resonant frequency serving as a base. However, since the temperature change still occurs due to the reflected heat from a tray or the substrate and the change of the resonant frequency occurs, the monitoring value of the film formation speed is affected.

JP S60 93303 A discloses that the temperature change is detected by a temperature sensor and the monitoring value of the film formation speed is corrected according to the temperature change. However, since not only it is difficult to put the temperature sensor in the completely same temperature environment as the film thickness sensor, but also the temperature change is the greatest on the surface where the film thickness sensor is exposed and the change becomes smaller toward the inner side, the influence of the temperature change on the film thickness sensor is complicated. For this reason, even if the film formation speed calculated by the film thickness sensor is corrected on the basis of the temperature change detected by the temperature sensor, it is difficult to remove the influence of the reflected heat from the tray, the substrate, or the like on the monitoring value of the film formation speed.

The invention has been made to improve the above-described problems, and has the object to provide a vacuum vapor deposition apparatus that can suppress the temperature change of a film thickness sensor caused by reflected heat from a target, to more precisely control a film formation speed.

### Solution to Problem

This object is solved by a vacuum vapor deposition apparatus with the features of claim 1. Preferred embodiments follow from the other claims.

The vacuum vapor deposition apparatus of the invention includes an evaporation source that is disposed to face a position where a target is disposed; an evaporation source cover that surrounds the evaporation source and has a discharge port through which a vapor deposition material is discharged; a deposition preventing board that is disposed around the evaporation source cover to prevent scattering of the vapor deposition material, and has an opening through which the target is exposed to the evaporation source; a film thickness sensor that is arranged to face the evaporation source, in a space surrounded by the deposition preventing board; and heat reflection suppressor that is provided in at least a portion of a region where heat radiated from the evaporation source and reflected by the target is capable of being re-reflected and radiated to the film thickness sensor and suppresses heat which is capable of being radiated to the film thickness sensor.

According to this configuration, the heat reflection suppressor provided at the position where heat can be re-reflected by the evaporation source cover or the deposition preventing board and radiated to the film thickness sensor can keep the heat dissipated from the evaporation source and reflected by the target from being re-reflected and radiated to the film thickness sensor. For this reason, the quantity of heat radiated to the film thickness sensor by re-reflection can be suppressed, and the temperature change of the film thickness sensor can be suppressed. Accordingly, the detection error of film thickness depending on a temperature change in the film thickness sensor can be suppressed, and film formation speed can be more precisely controlled.

Additionally, in the above vacuum vapor deposition apparatus, the heat reflection suppressor includes heat absorber for absorbing the heat reflected by the target.

According to this configuration, the radiation of the re-reflected heat to the film thickness sensor can be suppressed by absorbing the heat reflected by the target.

Additionally, in the above vacuum vapor deposition apparatus, the heat reflection suppressor includes heat interceptor for intercepting the heat reflected by the target and re-reflected by the evaporation source cover or the deposition preventing board.

According to this configuration, the radiation of the re-reflected heat to the film thickness sensor can be suppressed by intercepting the heat reflected by the target and re-reflected by the evaporation source cover or the deposition preventing board.

Additionally, in the above vacuum vapor deposition apparatus, the heat reflection suppressor includes heat transmitter for allowing the heat reflected by the target to be transmitted therethrough.

According to this configuration, the radiation of the re-reflected heat to the film thickness sensor can be suppressed by allowing the heat reflected by the target to be transmitted from the through-hole to the outside of the space surrounded by the deposition preventing board.

Additionally, in the above vacuum vapor deposition apparatus, the heat reflection suppressor includes heat reflector for reflecting the heat reflected by the target in a direction avoiding the film thickness sensor.

According to this configuration, the radiation of the re-reflected heat to the film thickness sensor can be suppressed by reflecting the heat reflected by the target toward places other than the film thickness sensor.

Additionally, in the above vacuum vapor deposition apparatus, the heat reflection suppressor includes heat retro-reflector for returning the heat reflected by the target in a direction from which the heat entered.

According to this configuration, the radiation of the re-reflected heat to the film thickness sensor can be suppressed by returning the heat reflected by the target in the direction from which the heat entered.

Additionally, the vacuum vapor deposition apparatus further includes a film thickness sensor cover that surrounds at least a portion of the film thickness sensor.

According to this configuration, the radiation of the reflected heat to the film thickness sensor can be suppressed by limiting the range of exposure of the film thickness sensor to the heat reflected by the target, using the film thickness sensor cover.

Additionally, in the above vacuum vapor deposition apparatus, the heat absorber may be obtained by a blackening treatment.

According to this configuration, the heat reflected by the target can be absorbed by a surface subjected to the blackening treatment.

Additionally, in the above vacuum vapor deposition apparatus, heat diffuser may be obtained by blast processing.

According to this configuration, the heat reflected by the target can be diffused by a surface subjected to the blast processing.

Additionally, in the above vacuum vapor deposition apparatus, the heat interceptor may be at least one welded fin.

According to this configuration, the heat reflected by the target and reflected again and radiated to the film thickness sensor can be intercepted by the fin.

Additionally, in the above vacuum vapor deposition apparatus, the heat transmitter may be a through-hole formed by bending a notch.

According to this configuration, the heat reflected by the target can be transmitted to the outside of the deposition preventing board through the through-hole without being reflected again.

Additionally, in the above vacuum vapor deposition apparatus, the heat reflector may be the evaporation source cover having an inclined surface with a predetermined angle.

According to this configuration, the heat reflected by the target and radiated to the evaporation source cover can be reflected toward places other than the film thickness sensor by the inclined surface.

Additionally, in the above vacuum vapor deposition apparatus, the heat retro-reflector may be a corner cube array or a bead-containing coating material.

According to this configuration, the heat reflected by the target can be returned in the direction from which the heat entered, by the corner cube array or the bead-containing coating material.

Additionally, the film thickness sensor cover may include a tubular hood of which an inner surface is blackened.

According to this configuration, the radiation of the reflected heat to the film thickness sensor can be suppressed by limiting the angle at which the re-reflected heat can enter the film thickness sensor.

### Advantageous Effects of Invention

According to the vacuum vapor deposition apparatus of the invention, the film formation speed can be more precisely controlled by preventing the heat dissipated from the evaporation source and reflected by the substrate from being radiated to the film thickness sensor, and by reducing a change in the environmental temperature in the film thickness sensor.

### Brief Description of Drawings

FIG. 1 is a schematic view illustrating a vacuum vapor deposition apparatus including a deposition preventing board having heat reflection suppressor, and an evaporation source cover, according to the invention.
FIG. 2 is a schematic view illustrating a vacuum vapor deposition apparatus including a deposition preventing board having a plurality of welded fins, according to the invention.
FIG. 3A is a schematic view illustrating a vacuum vapor deposition apparatus including a deposition preventing board having a plurality of fins formed by bending notches, according to the invention.
FIG. 3B is an enlarged view of the fins formed by bending the notches in FIG. 3A.
FIG. 4 is a schematic view illustrating a vacuum vapor deposition apparatus including an evaporation source cover having an inclined surface, according to the invention.
FIG. 5A is a schematic view illustrating a vacuum vapor deposition apparatus to which a corner cube array is given, according to the invention.
FIG. 5B is a view illustrating the principle of a corner cube.
FIG. 5C is a view illustrating an enlarged view of the surface of the corner cube array.
FIG. 6A is a schematic view illustrating a vacuum vapor deposition apparatus including a film thickness sensor covered with a film thickness sensor cover, according to the invention.
FIG. 6B is a schematic view illustrating a vacuum vapor deposition apparatus including a film thickness sensor cover provided with a tubular hood.
FIG. 7 is graph in a case where a film formation speed detected by the vacuum vapor deposition apparatus including the heat reflection suppressor according to the invention, a film formation speed detected by the vacuum vapor deposition apparatus that does not include the heat reflection suppressor according to the invention, and an actual film formation speed in a substrate are compared.

### Description of Embodiments

Vapor deposition apparatuses of a plurality of embodiments according to the invention will be described below with reference to the drawings. Additionally, a target in the present specification includes a substrate 20, a tray 24, a mask (not illustrated), or the like in the following embodiments.

### [First Embodiment]

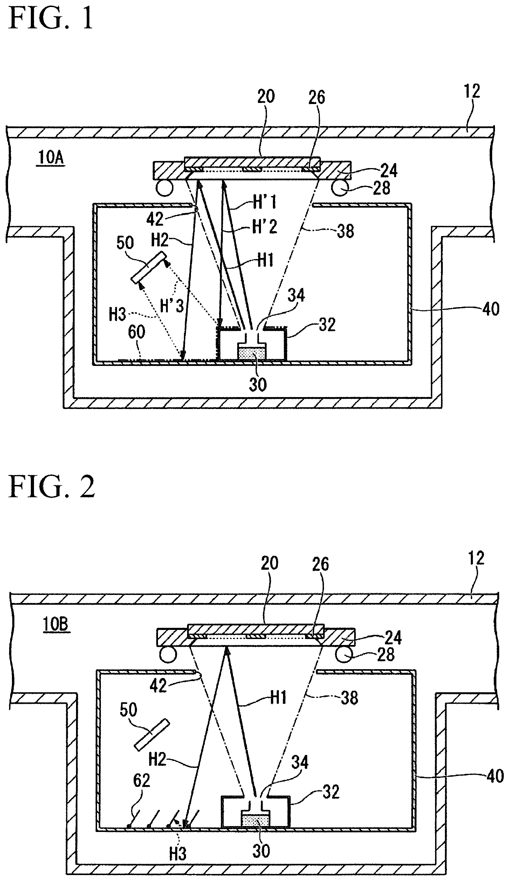

A vacuum vapor deposition apparatus 10A according to the invention illustrated in FIG. 1 includes a vacuum chamber 12 that is brought into a vacuum atmosphere, and a conveying roller 28 having a roller that conveys a target into the vacuum chamber 12, and a thin film having a predetermined thickness is formed by vapor-depositing a vapor deposition material 38 on the target conveyed at a vapor deposition position within the vacuum chamber 12. In the present embodiment, the substrate 20 that is a member to be vapor-deposited is loaded on the tray 24 in a state where a mask 26 for vapor-depositing a predetermined range is attached, and the tray 24, the mask 26, and the substrate 20 are integrally conveyed as the target by the conveying roller 28. Additionally, the vacuum vapor deposition apparatus 10A includes an evaporation source 30 that discharges the vapor deposition material, an evaporation source cover 32 that surrounds the evaporation source 30, a deposition preventing board 40 that prevents scattering of the discharged vapor deposition material 38, and a film thickness sensor 50 that detects the thickness of a film formed of the vapor deposition material. The evaporation source 30 is disposed to face the target disposed at the vapor deposition position. The evaporation source cover 32 is provided with a discharge port 34 through which the vapor deposition material is discharged, and prevents the vapor deposition material and heat from being scattered other than from the discharge port 34. The deposition preventing board 40 having an opening 42 that exposes the substrate 20 to the evaporation source 30, and the film thickness sensor 50 that is disposed toward the evaporation source 30 in a space surrounded by the deposition preventing board, is disposed at a position where the vapor deposition of the vapor deposition material to the substrate 20 is not hindered, and detects the thickness of the thin film formed of the vapor deposition material are included.

The film thickness sensor 50 in the present embodiment includes a crystal oscillator. The film thickness sensor 50 measures the resonant frequency of the crystal oscillator. The vapor deposition material 38 discharged from the evaporation source 30 adheres to the crystal oscillator, a film is formed on a surface of the crystal oscillator, and the resonant frequency changes according to the film thickness of the film. In the film thickness sensor 50 in the present embodiment, the film thickness of the film formed of the vapor deposition material is found on the basis of the resonant frequency to be detected, a film formation speed is found on the basis of the time change of the film thickness, and a film formation speed is controlled according to the found film formation speed.

Additionally, the vacuum vapor deposition apparatus 10A includes heat reflection suppressor 60 that re-reflects the heat which is dissipated from the evaporation source 30 and reflected by the target and suppresses the heat which can be radiated to the film thickness sensor 50. In the present embodiment, the heat reflection suppressor 60 is formed with heat absorber by subjecting a blackening treatment to regions on an inner surface of the deposition preventing board 40 and an outer surface of the evaporation source cover where the heat dissipated from the evaporation source 30 and reflected by the target can be re-reflected toward the film thickness sensor 50. Specifically, the blackening treatment is performed, for example, by surface processing, such as plating.

When the substrate 20 passes above the evaporation source 30, upward heat (H1, H'1) radiated from the evaporation source 30 and heated by a heater is reflected by the substrate 20 or the tray 24 (H2, H'2), and is then re-reflected by the evaporation source cover 32 or the deposition preventing board 40, and a portion (H3, H'3) of the re-reflected heat is radiated to the film thickness sensor 50. In this way, as the heat (H3, H'3) re-reflected by the evaporation source cover 32 or the deposition preventing board 40 is radiated to the film thickness sensor, the temperature change of the crystal oscillator occurs and the resonant frequency changes. Due to the change of the resonant frequency, a film formation speed detected by the film thickness sensor fluctuates even if an actual film formation speed has not changed. The vacuum vapor deposition apparatus also affects the actual film formation speed because the vacuum vapor deposition apparatus attempts to control the film formation speed on the basis of the displaced film formation speed detected by the film thickness sensor.

In the region that has been subjected to the blackening treatment, the re-reflection (H3, H'3) of the heat directed to the film thickness sensor 50 is suppressed by absorbing the heat (H2, H'2) reflected by the substrate 20 that is the target or by the tray 24. Accordingly, when the substrate 20 passes through the vapor deposition position above the evaporation source 30, the displacement of the amount of radiant heat that enters the crystal oscillator of the film thickness sensor 50 can be suppressed, the measurement error of the film thickness detected by the film thickness sensor 50 can be suppressed, and the film formation speed can be more precisely controlled.

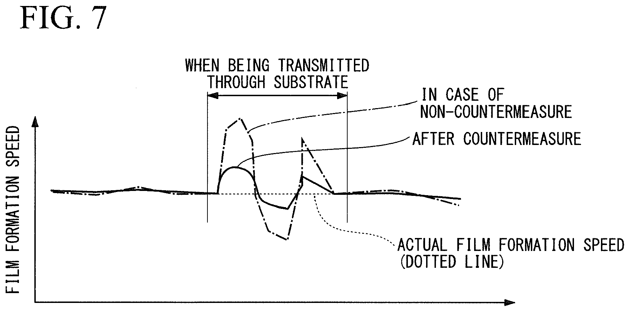

A graph obtained by comparing a film formation speed (after a countermeasure) detected by the film thickness sensor 50 when the above-described heat reflection suppressor 60 is provided on the inner surface of the deposition preventing board 40 and on the outer surface of the evaporation source cover, a film formation speed (a non-countermeasure) detected in case of a non-countermeasure, and an actual film formation speed is illustrated in FIG. 7. When the substrate 20 passes above the evaporation source, according to a difference in the shape or material of the target, the heat reflected from the target consisting of the substrate 20, the tray 24, and the mask 26 changes with time and the re-reflection of the heat received by the film forming sensor similarly changes with time. Although this influences the film formation speed detected by the film thickness sensor 50, the change of the film formation speed after the countermeasure is suppressed compared to that in case of the non-countermeasure, and monitoring of a speed closer to the actual film formation speed, that is, a more precise film formation speed, is realized.

### [Second Embodiment]

Additionally, as the heat reflection suppressor 60 in FIG. 1, blast treatment or the like may be provided instead of the blackening treatment. The blast treatment functions as heat diffuser for diffusing the heat (H2, H'2) reflected by the substrate 20 or the tray 24, and also functions as heat absorber for absorbing the heat (H2, H'2) reflected by the substrate 20 or the tray 24.

According to a second embodiment, the re-reflection (H3, H'3) of the heat that is directed to the film thickness sensor 50 by diffusing or absorbing the heat (H2, H'2) reflected by the substrate 20 or the tray 24 in the inner surface of the deposition preventing board 40 and the outer surface of the evaporation source cover 32 subjected to the blast treatment can be suppressed.

In addition, similarly, functioning as the heat diffuser and also as the heat absorber is not limited to this blast treatment. For example, the re-reflection (H3, H'3) of the heat directed to the film thickness sensor 50 may be suppressed by attaching a metallic mesh-like sheet, or a porous sheet formed by roughly sintering a particulate or fibrous metallic material, and by diffusing or absorbing the heat with irregularities provided in the surface of the sheet.

In addition, the heat reflection suppressor 60 in the first and second embodiments may be given to the whole surface of the deposition preventing board 40 or the evaporation source cover 32 as illustrated in FIG. 1, or may be given only to the region that can re-reflect the heat toward the film thickness sensor 50.

### [Third Embodiment]

As illustrated in FIG. 2, in a vacuum vapor deposition apparatus 10B of the present embodiment, heat interceptor consisting of a plurality of fins 62 fixed to the deposition preventing board 40 is provided as the heat reflection suppressor. The plurality of fins 62 are fixed at a predetermined angle with respect to the deposition preventing board 40.

Specifically, the plurality of fins 62 are attached at an angle so that the heat directed to the film thickness sensor by the heat dissipated from the evaporation source 30 and reflected by the target being re-reflected is intercepted and so that the heat reflected by the fins 62 does not enter the film thickness sensor 50. In the present embodiment, although the plurality of fins 62 are fixed to the deposition preventing board 40 by welding, the fins may be fixed by another fixing means.

The fins 62 intercept a portion of the heat re-reflected by the deposition preventing board 40 in the heat dissipated from the evaporation source 30 and reflected by the target, and suppresses entering of the heat into the film thickness sensor 50. Additionally, the heat reflected by the target is re-reflected so as not to enter the film thickness sensor 50. Accordingly, the re-reflection (H3) of the heat directed to the film thickness sensor 50 can be suppressed by intercepting the heat (H2) reflected by the substrate 20 or the tray 24 with the fins 62.

### [Fourth Embodiment]

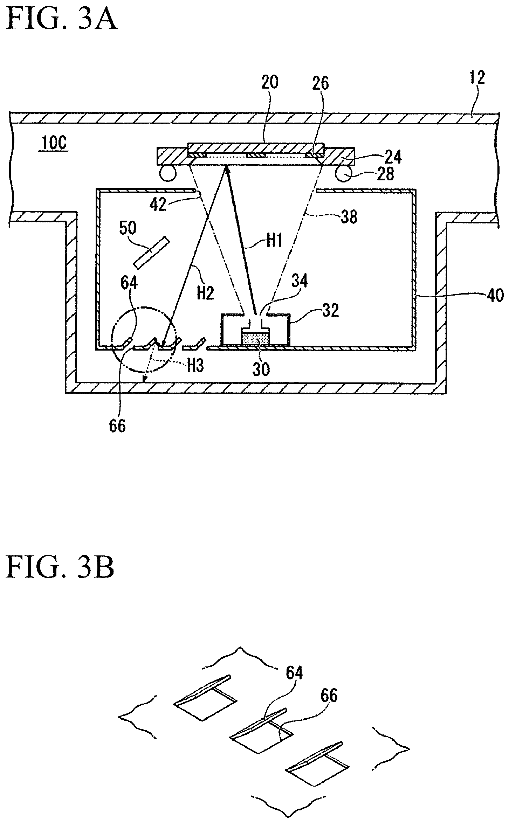

Additionally, FIG. 3A illustrates a modification example of the third embodiment. As illustrated in FIG. 3A, in the present modification example, fins 64 that are heat interceptor, and through-holes 66 in the deposition preventing board 40 that are heat transmitter are provided as the heat reflection suppressor. In the deposition preventing board 40, a plurality of fins 64 are formed by bending notches made in a region where the heat dissipated from the evaporation source 30 and reflected by the target can be re-reflected toward the film thickness sensor 50, and the through-holes 66 are formed in original portions by forming the fins 64 (refer to FIG. 3B). In the present modification example, the fins 64, as described above, are bent at an angle such that the heat re-reflected toward the film thickness sensor 50 is intercepted and the heat reflected by the fins 64 is re-reflected so as not to enter the film thickness sensor 50.

In the present embodiment, similarly, the fins 64 intercept a portion of the heat re-reflected by the deposition preventing board 40 in the heat dissipated from the evaporation source 30 and reflected by the target, and suppress entering of the heat into the film thickness sensor 50. Additionally, the heat reflected by the target is re-reflected so as not to enter the film thickness sensor 50. Moreover, the through-holes 66 formed by bending allow the heat (H2) reflected by the substrate 20, the tray 24, or the target to be transmitted to the outside of the space surrounded by the deposition preventing board 40, and thereby suppress entering of the heat into the film thickness sensor 50 through the re-reflection.

In addition, only the through-holes may be provided as the heat reflection suppressor without providing the fins. Additionally, when the deposition preventing board 40 is provided with the through-holes, it is desirable to provide the through-holes so as to avoid a place where the vapor deposition material 38 can be discharged from the deposition preventing board 40 into the vacuum chamber 12.

In addition, all of the plurality of fins 62 and 64 in the third and fourth embodiments may be fixed at the same angle or may be fixed at suitable different angles depending on each area in consideration of a positional relationship with the film thickness sensor 50. That is, the angle of the plurality of fins 62 or 64 may be arbitrarily determined within a range where the heat obtained by the reflected heat H2 from the target being re-reflected to the film thickness sensor 50 in the inner surface of the deposition preventing board 40 and the outer surface of the evaporation source cover 32 is intercepted, and the heat re-reflected by the fins 62 or 64 themselves is reflected toward places other than the film thickness sensor 50.

### [Fifth Embodiment]

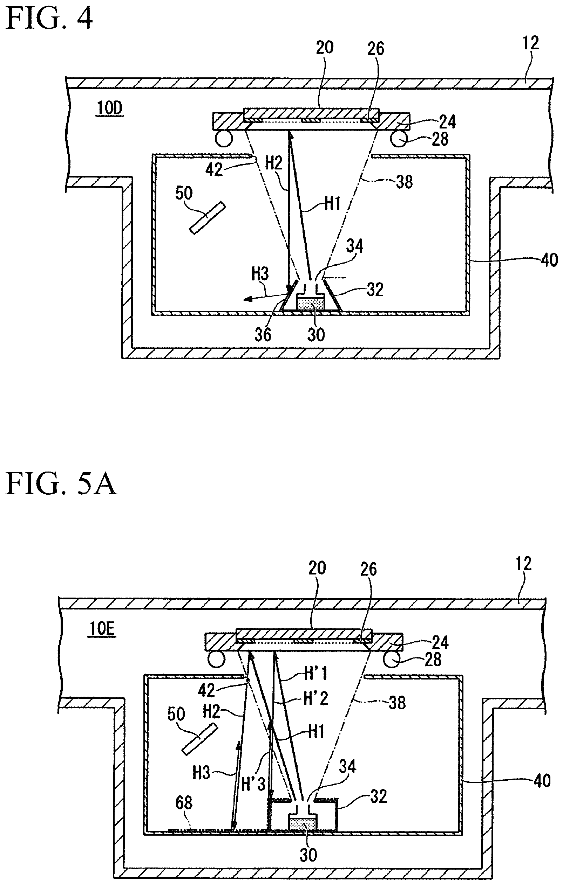

A vacuum vapor deposition apparatus 10D according to the invention illustrated in FIG. 4 includes an evaporation source cover 32 having an inclined surface 36. The inclined surface 36 of the evaporation source cover is formed at an angle such that the heat (H2) reflected by the target, such as the substrate 20 or the tray 24, is re-reflected in a direction avoiding the film thickness sensor 50, and constitutes the heat reflection suppressor in the present embodiment. The evaporation source cover in the present embodiment adopts the pyramidal evaporation source cover 32, and the lateral surface of the evaporation source cover is used as the inclined surface 36 that constitutes the heat reflector.

The angle of the inclined surface 36 may be appropriately determined so that heat is not re-reflected toward the film thickness sensor 50 according to the position of the film thickness sensor 50, and the inclined surface may not have a bilaterally symmetrical shape as illustrated in FIG. 3A but may have a bilaterally asymmetrical shape. Additionally, the inclined surface may have a shape such that a horizontal plane or a vertical plane is left behind according to the position of the film thickness sensor 50.

Although FIG. 4 illustrates a form in which the inclined surface 36 is provided at the evaporation source cover 32 to form the heat reflector, the inclined surface may similarly be provided at the deposition preventing board. The heat reflector reflects the heat obtained by the reflected heat H2 from the target being re-reflected by the deposition preventing board toward places other than the film thickness sensor 50, thereby suppressing entering of the heat into the film thickness sensor 50.

### [Sixth Embodiment]

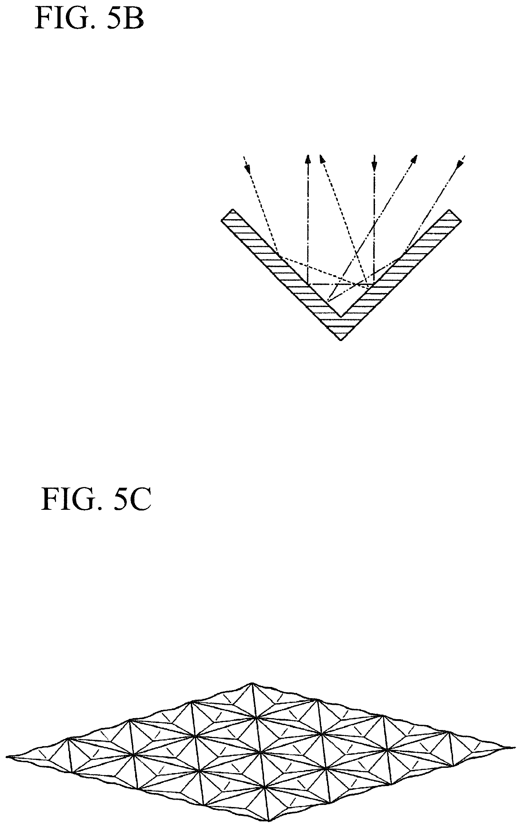

Additionally, as another heat reflector, in a vacuum vapor deposition apparatus 10E according to the invention illustrated in FIG. 5A, a corner cube array 68, which is heat retro-reflector having a shape as illustrated in FIG. 5C as the heat reflector, is given to regions where the heat dissipated from the evaporation source 30 and reflected by the target can be re-reflected toward the film thickness sensor 50, in the inner surface of the deposition preventing board 40 and the outer surface of the evaporation source cover, instead of providing the inclined surface at the deposition preventing board.

The corner cube reflects the heat, which has entered at an arbitrary angle of incidence, in the same direction as the angle of incidence, as the principle thereof is illustrated in FIG. 5B. Therefore, if the reflected heat (H2, H'2) from the target is radiated on the surface to which the corner cube array is given, the heat is reflected in the same direction as the direction from which the heat entered. This can prevent the re-reflected heat (H3, H'3) from being radiated toward the film thickness sensor 50.

In addition, as well as the corner cube array, general retroreflection processing methods, such as a method using a bead-containing coating material, can be used. Additionally, instead of performing the retroreflection processing on the deposition preventing board 40 or the evaporation source cover 32 itself, a sheet-like thin plate subjected to the retroreflection processing may be attached to the deposition preventing board 40 or the evaporation source cover 32.

### [Seventh embodiment]

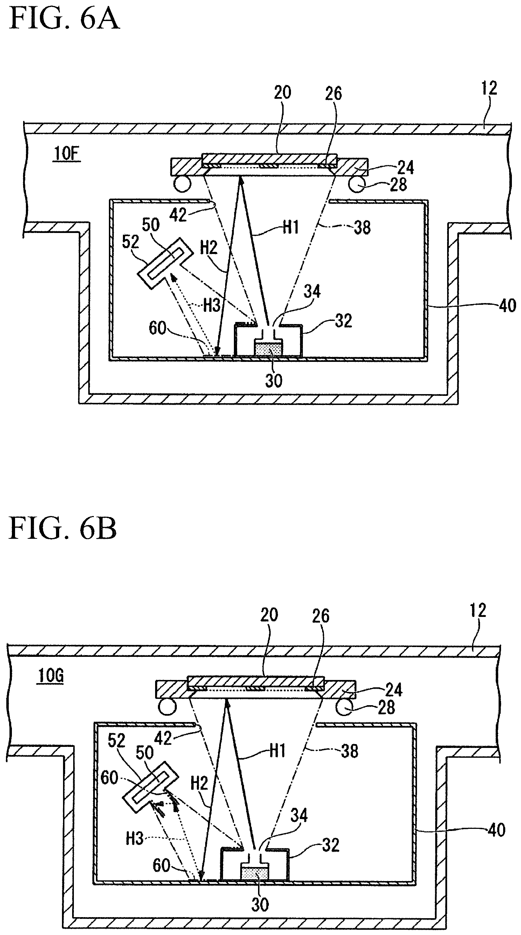

FIG. 6A illustrates a vacuum vapor deposition apparatus 10F according to the invention. As illustrated in FIG. 6A, the vacuum vapor deposition apparatus 10F includes a film thickness sensor cover 52 that covers portions other than a sensor unit of the film thickness sensor 50. Accordingly, the film thickness sensor 50 can detect film thickness while suppressing radiation of the re-reflected heat to the film thickness sensor 50 from the surroundings, and the influence caused by the radiation of the heat from the surroundings can be suppressed so as to control film formation.

Additionally, when the film thickness sensor cover 52 is attached, the region where the heat (H2) of the evaporation source cover 32 or the deposition preventing board 40 reflected by the target can be re-reflected and radiated to the film thickness sensor is more narrowly limited. Therefore, the area for providing the heat reflection suppressor 60 can be made small.

### [Eighth Embodiment]

Additionally, as illustrated in FIG. 6B, a tubular hood 54 may be provided at the film thickness sensor cover 52 in order to further limit the region where the heat of the evaporation source cover 32 or the deposition preventing board 40 reflected by the target can be re-reflected and radiated to the film thickness sensor (50). The hood 54 limits an angle at which the re-reflected heat can enter the film thickness sensor. Accordingly, the region where the heat of the evaporation source cover 32 or the deposition preventing board 40 reflected by the target can be re-reflected and radiated to the film thickness sensor is further limited.

Additionally, the aforementioned blackening treatment, blast processing, or retroreflection processing can be performed on the inner surface of the hood 54. By adopting such a configuration, the film formation speed can be more precisely detected by suppressing entering of the heat, which is reflected into the inner surface of the hood 54 in the heat that has entered the hood 54, into the film thickness sensor 50 and by suppressing the heat that enters the film thickness sensor 50.

Although the various embodiments of the invention have been described above as examples, these embodiments may be combined and carried out within a technically possible range so that higher effects are obtained. For example, the blackening process may be performed on the plurality of fins 62 and 64 of the second embodiment. Otherwise, for example, the deposition preventing board 40 may be provided with the plurality of fins 62 or 64, and the evaporation source cover 32 may be provided with the corner cube array.

In addition, the target in the invention is not limited to the substrate 20, the tray 24, and the mask 26, but refers to an arbitrary structure that can cover the opening 42 of the deposition preventing board, and reflect the heat (H1) dissipated from the evaporation source 30.

In addition, the heat reflection suppressor 60 according to the invention are not limited to being provided at the evaporation source cover 32 and the deposition preventing board 40, but may be provided on the surface of an arbitrary structure that is disposed within a space surrounded by the deposition preventing board 40.

Although the various embodiments of the vacuum vapor deposition apparatus according to the invention have been described so far, the vapor deposition apparatus of the invention can be modified, and appropriate modifications, improvements, or the like can be made. For example, by disposing a temperature sensor that measures the temperature of the film thickness sensor 50, and using the correction of the film formation speed together depending on the monitoring of a temperature change, it is possible to more precisely control the film formation speed.

### Industrial Applicability

The invention according to the vacuum vapor deposition apparatus that can suppress the temperature change of the film thickness sensor caused by the reflected heat from the target, to more precisely control the film formation speed.

### Reference Signs List

10A, 10B, 10C, 10D, 10E, 10F, 10G: VACUUM VAPOR DEPOSITION APPARATUS
12: VACUUM CHAMBER
20: SUBSTRATE
24: TRAY
26: MASK
28: CONVEYING ROLLER
30: EVAPORATION SOURCE
32,33: EVAPORATION SOURCE COVER
34: DISCHARGE PORT
36: INCLINED SURFACE
38: VAPOR DEPOSITION MATERIAL
40: DEPOSITION PREVENTING BOARD
42: OPENING
50: FILM THICKNESS SENSOR
52: FILM THICKNESS SENSOR COVER
54: HOOD
60: HEAT REFLECTION SUPPRESSOR
62,64: FIN
66: THROUGH HOLE
68: CORNER CUBE ARRAY
H1, H'1: HEAT FROM EVAPORATION SOURCE
H2, H'2: HEAT REFLECTED BY TARGET
H3, H'3, H4: RE-REFLECTED HEAT

## Claims

1. A vacuum vapor deposition apparatus comprising:
an evaporation source (30) that is disposed so that a vapor deposition material (38) is discharged toward a position where a target (20, 24) is disposed;
an evaporation source cover (32) that surrounds the evaporation source (30) and has a discharge port (34) through which the vapor deposition material (38) is discharged;
a deposition preventing board (40) that is disposed around the evaporation source cover (32) to prevent scattering of the vapor deposition material (38), and has an opening (42) through which the target (20, 24) is exposed to the evaporation source (30); and
a film thickness sensor (50) that is arranged in a space surrounded by the deposition preventing board (40) and detects the thickness of a film formed of the vapor deposition material (38) discharged from the evaporation source (30);
**characterized in that** the vacuum vapor deposition apparatus further comprises:
a heat reflection suppressor (60) that is provided by an inner surface of the deposition preventing board (40) and an outer surface of the evaporation source cover_ (32) that is provided at a position where heat radiated from the evaporation source (30) and reflected by the target (20, 24) is re-reflected and radiated to the film thickness sensor (50), and that is configured to suppress heat which is radiated to the film thickness sensor (50).

2. The vacuum vapor deposition apparatus according to Claim 1,
wherein the heat reflection suppressor (60) includes heat absorber for absorbing the heat reflected by the target (20, 24).

3. The vacuum vapor deposition apparatus according to Claim 1 or 2,
wherein the heat reflection suppressor (60) includes heat diffuser for diffusing the heat reflected by the target (20, 24).

4. The vacuum vapor deposition apparatus according to any one of Claims 1 to 3,
wherein the heat reflection suppressor (60) includes heat interceptor (62) for intercepting the heat reflected by the target (20, 24).

5. The vacuum vapor deposition apparatus according to any one of Claims 1 to 4,
wherein the heat reflection suppressor (60) includes heat transmitter (66) for allowing the heat reflected by the target (20, 24) to be transmitted therethrough.

6. The vacuum vapor deposition apparatus according to any one of Claims 1 to 5,
wherein the heat reflection suppressor (60) includes heat reflector (36) for reflecting the heat reflected by the target (20, 24) in a direction avoiding the film thickness sensor (50).

7. The vacuum vapor deposition apparatus according to any one of Claims 1 to 6,
wherein the heat reflection suppressor (60) includes heat retro-reflector (68) for returning the heat reflected from the target (20, 24) in a direction from which the heat entered.

8. The vacuum vapor deposition apparatus according to Claim 2,
wherein the heat absorber is obtained by a blackening treatment.

9. The vacuum vapor deposition apparatus according to Claim 3,
wherein the heat diffuser is obtained by blast processing.

10. The vacuum vapor deposition apparatus according to Claim 2,
wherein the heat absorber is obtained by blast processing.

11. The vacuum vapor deposition apparatus according to Claim 4,
wherein the heat interceptor (62) includes at least one fin attached to the deposition preventing board (40).

12. The vacuum vapor deposition apparatus according to Claim 5,
wherein the heat transmitter (66) includes a through-hole (66) formed in the deposition preventing board (40).

13. The vacuum vapor deposition apparatus according to Claim 6,
wherein the heat reflector (36) includes an inclined surface (36) that is provided at the evaporation source cover (32) and is formed at an angle such that the heat reflected by the target (20, 24) is reflected in a direction avoiding the film thickness sensor (50).

14. The vacuum vapor deposition apparatus according to Claim 7,
wherein the heat retro-reflector (68) has a corner cube array (68) or a bead-containing coating material.

## Patentansprüche

1. Vakuumdampfabscheidungsvorrichtung umfassend:
eine Verdampfungsquelle (30), die so angeordnet ist, dass ein Dampfabscheidungsmaterial (38) zu einer Position hin abgeschieden wird, wo ein Target (20, 24) angeordnet ist;
eine Verdampfungsquellenabdeckung (32), die die Verdampfungsquelle (30) umgibt und eine Abgabeöffnung (34) aufweist, durch welche das Dampfabscheidungsmaterial (38) abgegeben wird;
eine Abscheidungsverhinderungsplatte (40), die um die Verdampfungsquellenabdeckung (32) herum angeordnet ist, um eine Streuung des Dampfabscheidungsmaterials (38) zu verhindern, und eine Öffnung (42) aufweist, durch welche das Target (20, 24) gegenüber der Verdampfungsquelle (30) exponiert ist; und
einen Filmdickensensor (50), der in einem Raum angeordnet ist, welcher durch die Abscheidungsverhinderungsplatte (40) umgeben ist und der die Dicke eines Films erfasst, der durch das von der Verdampfungsquelle (30) abgegebene Dampfabscheidungsmaterial (38) gebildet ist;
**dadurch gekennzeichnet, dass** die Vakuumdampfabscheidungsvorrichtung weiter umfasst:
einen Wärmereflexionsunterdrücker (60), der durch eine Innenfläche der Abscheidungsverhinderungsplatte (40) und eine Außenfläche der Verdampfungsquellenabdeckung (32) bereitgestellt wird, der an einer Position vorgesehen ist, wo die von der Verdampfungsquelle (30) abgestrahlte und vom Target (20, 24) reflektierte Wärme erneut reflektiert und zum Filmdickensensor 50 gestrahlt wird,
und der ausgestaltet ist, die Wärme zu unterdrücken, welche zum Filmdickensensor (50) abgestrahlt wird.

2. Vakuumdampfabscheidungsvorrichtung nach Anspruch 1,
wobei der Wärmereflexionsunterdrücker (30) einen Wärmeabsorber zum Absorbieren der vom Target (20, 24) reflektierten Wärme umfasst.

3. Vakuumdampfabscheidungsvorrichtung nach Anspruch 1 oder 2,
wobei der Wärmereflexionsunterdrücker (30) einen Wärmediffusor zum Streuen der vom Target (20, 24) reflektierten Wärme umfasst.

4. Vakuumdampfabscheidungsvorrichtung nach einem der Ansprüche 1 bis 3,
wobei der Wärmereflexionsunterdrücker (60) einen Wärmefänger (62) zum Abfangen der vom Target (20, 24) reflektierten Wärme umfasst.

5. Vakuumdampfabscheidungsvorrichtung nach einem der Ansprüche 1 bis 4,
wobei der Wärmereflexionsunterdrücker (60) einen Wärmeüberträger (66) umfasst, um es der vom Target (20, 24) reflektierten Wärme zu erlauben, durch ihn transmittiert zu werden.

6. Vakuumdampfabscheidungsvorrichtung nach einem der Ansprüche 1 bis 5,
wobei der Wärmereflexionsunterdrücker (60) einen Wärmereflektor (36) zum Reflektieren der vom Target (20, 24) reflektierten Wärme in eine den Filmdickensensor (50) vermeidende Richtung umfasst.

7. Vakuumdampfabscheidungsvorrichtung nach einem der Ansprüche 1 bis 6,
wobei der Wärmereflexionsunterdrücker (60) einen Wärme-Retroreflektor (68) umfasst, um die vom Target (20, 24) reflektierte Wärme in eine Richtung zurückzuschicken, aus welcher die Wärme eintrat.

8. Vakuumdampfabscheidungsvorrichtung nach Anspruch 2,
wobei der Wärmeabsorber durch eine Schwärzungsbehandlung erhalten wird.

9. Vakuumdampfabscheidungsvorrichtung nach Anspruch 3,
wobei der Wärmediffusor durch eine Strahlbehandlung erhalten wird.

10. Vakuumdampfabscheidungsvorrichtung nach Anspruch 2,
wobei der Wärmeabsorber durch eine Strahlbehandlung erhalten wird.

11. Vakuumdampfabscheidungsvorrichtung nach Anspruch 4,
wobei der Wärmefänger (62) mindestens eine an der Abscheidungsverhinderungsplatte (40) angebrachte Lamelle umfasst.

12. Vakuumdampfabscheidungsvorrichtung nach Anspruch 5,
wobei der Wärmeüberträger (66) ein in der Abscheidungsverhinderungsplatte (40) ausgebildetes, durchgehendes Loch (66) umfasst.

13. Vakuumdampfabscheidungsvorrichtung nach Anspruch 6,
wobei der Wärmereflektor (36) eine geneigte Fläche (36) umfasst, die an der Verdampfungsquellenabdeckung (32) vorgesehen ist und unter einem Winkel ausgebildet ist, so dass die vom Target (20, 24) reflektierte Wärme in eine Richtung reflektiert wird, die den Filmdickensensor (50) vermeidet.

14. Vakuumdampfabscheidungsvorrichtung nach Anspruch 7,
wobei der Wärme-Retroreflektor (68) eine Triplespiegelanordnung (58) oder ein Sicken enthaltendes Beschichtungsmaterial aufweist.

## Revendications

1. Appareil de dépôt en phase vapeur sous vide, comprenant :
une source d'évaporation (30) qui est disposée d'une manière telle qu'une matière de dépôt en phase vapeur (38) est déchargée en direction d'une position où est disposée une cible (20, 24) ;
un recouvrement de source d'évaporation (32) qui entoure la source d'évaporation (30) et qui possède un orifice de décharge (34) à travers lequel la matière de dépôt en phase vapeur (38) est déchargée ;
un panneau anti-dépôt (40) qui est disposé autour du recouvrement de source d'évaporation (32) pour empêcher une dispersion de la matière de dépôt en phase vapeur (38) et qui possède une ouverture (42) à travers laquelle la cible (20, 24) est exposée à la source d'évaporation (30) ; et
un détecteur d'épaisseur de film (50) qui est disposé dans un espace entouré par le panneau anti-dépôt (40) et détecte l'épaisseur d'un film formé de la matière de dépôt en phase vapeur (38) déchargée à partir de la source d'évaporation (30) ;
**caractérisé en ce que** l'appareil de dépôt en phase vapeur sous vide comprend en outre :
un dispositif de suppression de réflexion de chaleur (60) qui est fourni par une surface interne du panneau anti-dépôt (40) et une surface externe du recouvrement de source d'évaporation (32), qui est prévu dans une position où la chaleur irradiée à partir de la source d'évaporation (30) et réfléchie par la cible (20, 24) est réfléchie en retour et irradiée en direction du détecteur d'épaisseur de film (50), et qui est configuré pour supprimer la chaleur qui est irradiée en direction du détecteur d'épaisseur de film (50).

2. Appareil de dépôt en phase vapeur sous vide selon la revendication 1, dans lequel le dispositif de suppression de réflexion de chaleur (60) comprend un dispositif d'absorption de chaleur pour absorber la chaleur réfléchie par la cible (20, 24).

3. Appareil de dépôt en phase vapeur sous vide selon la revendication 1 ou 2, dans lequel le dispositif de suppression de réflexion de chaleur (60) comprend un dispositif de diffusion de chaleur pour diffuser la chaleur réfléchie par la cible (20, 24).

4. Appareil de dépôt en phase vapeur sous vide selon l'une quelconque des revendications 1 à 3, dans lequel le dispositif de suppression de réflexion de chaleur (60) comprend un dispositif d'interception de chaleur (62) pour intercepter la chaleur réfléchie par la cible (20, 24).

5. Appareil de dépôt en phase vapeur sous vide selon l'une quelconque des revendications 1 à 4, dans lequel le dispositif de suppression de réflexion de chaleur (60) comprend un dispositif de transmission de chaleur (66) pour permettre la transmission à travers lui de la chaleur réfléchie par la cible (20, 24).

6. Appareil de dépôt en phase vapeur sous vide selon l'une quelconque des revendications 1 à 5, dans lequel le dispositif de suppression de réflexion de chaleur (60) comprend un dispositif de réflexion de chaleur (36) pour réfléchir la chaleur réfléchie par la cible (20, 24) dans une direction qui évite le détecteur d'épaisseur de film (50).

7. Appareil de dépôt en phase vapeur sous vide selon l'une quelconque des revendications 1 à 6, dans lequel le dispositif de suppression de réflexion de chaleur (60) comprend un dispositif de rétro-réflexion de chaleur (68) pour renvoyer la chaleur réfléchie par la cible (20, 24) dans une direction d'où la chaleur est entrée.

8. Appareil de dépôt en phase vapeur sous vide selon la revendication 2, dans lequel le dispositif d'absorption de chaleur est obtenu via un traitement de noircissement.

9. Appareil de dépôt en phase vapeur sous vide selon la revendication 3, dans lequel le dispositif de diffusion de chaleur est obtenu via un traitement abrasif.

10. Appareil de dépôt en phase vapeur sous vide selon la revendication 2, dans lequel le dispositif d'absorption de chaleur est obtenu via un traitement abrasif.

11. Appareil de dépôt en phase vapeur sous vide selon la revendication 4, dans lequel le dispositif d'interception de chaleur (62) comprend au moins une ailette fixée au panneau anti-dépôt (40).

12. Appareil de dépôt en phase vapeur sous vide selon la revendication 5, dans lequel le dispositif de transmission de chaleur (66) comprend un trou traversant (66) formé dans le panneau anti-dépôt (40).

13. Appareil de dépôt en phase vapeur sous vide selon la revendication 6, dans lequel le dispositif de réflexion de chaleur (36) comprend une surface inclinée (36) qui est prévue sur le recouvrement de source d'évaporation (32) et qui forme un angle d'une manière telle que la chaleur réfléchie par la cible (20, 24) est réfléchie dans une direction qui évite le détecteur d'épaisseur de film (50).

14. Appareil de dépôt en phase vapeur sous vide selon la revendication 7, dans lequel le dispositif de rétro-réflexion de chaleur (68) possède une matrice prismatique (68) ou une matière d'enduction contenant des billes.
